# FASCICULE DE BREVET EUROPEEN

(11) **EP 3 490 007 B1**
(45) Date de publication et mention de la délivrance du brevet: **24.06.2020**
(21) Numéro de dépôt: 18207258.7
(22) Date de dépôt: 20.11.2018
(51) Int. Cl.: H01L 29/66

(54) **METHODE DE FABRICATION DE COUPLES DE TRANSISTORS CMOS DE TYPE " FIN-FET " A BASSE TEMPERATURE**
HERSTELLUNGSMETHODE VON KOPPELUNGEN VON CMOS-TRANSISTOREN VOM TYP FIN-FET BEI NIEDRIGER TEMPERATUR
METHOD FOR MANUFACTURING FIN-FET TYPE CMOS TRANSISTOR PAIRS AT LOW TEMPERATURE

(30) Priorité: 23.11.2017 FR 1761089
(43) Date de publication de la demande: 29.05.2019
(73) Titulaire: Commissariat à l'énergie atomique et aux énergies alternatives, 75015 Paris (FR)
(72) Inventeur: MATHIEU, Benoît, 38000 GRENOBLE (FR); BATUDE, Perrine, 21000 DIJON (FR)
(74) Mandataire: Brevalex

(56) Documents cités:
- US-A1- 2011 027 978
- US-A1- 2017 133 373

## Description

### DOMAINE TECHNIQUE ET ART ANTÉRIEUR

La présente demande concerne le domaine des transistors FinFET (pour « Fin-shaped Field Effect Transistor », ou transistor à effet de champ à ailette), ainsi que celui des dispositifs comportant de tels transistors.

Un transistor finFET est généralement formé à partir d'au moins une portion de semi-conducteur en forme d'ailette, c'est-à-dire un bloc de forme allongée ou oblongue qui comporte plusieurs faces distinctes dans le sens de sa longueur et est typiquement parallélépipédique. Une partie de l'ailette est destinée à former le canal du transistor contrôlé par une électrode de grille, généralement qualifiée d'enrobante.

Le document « Advances on doping stratégies for triple-gate finFETS and lateral gate all-around nanowire FETs and their impact on device performance » de Veloso et al., Materials Science in Semiconductor Processing 62 (2017)2-12 présente un exemple de réalisation d'un transistor finFET à grille enrobante.

Pour certaines applications, par exemple pour la mise en œuvre de circuits 3D avec des transistors réalisés sur plusieurs niveaux, on cherche à fabriquer des transistors finFET à basse température, c'est-à-dire à une température typiquement inférieure à 600°C.

La fabrication des transistors sur les niveaux supérieurs est facilitée et produit potentiellement des transistors de meilleure qualité si une température plus élevée peut être utilisée. En revanche, plus la température est élevée, plus les transistors des couches inférieures sont dégradés par les traitements thermiques.

Dans ce cadre, le dopage et l'activation de dopants de type N ou P dans des régions de l'ailette situées de part et d'autre de la grille pose problème. Le dopage de régions de l'ailette destinées à être situées sous des espaceurs isolants agencés contre la structure de grille s'avère tout particulièrement délicate. Avec les procédés de fabrication connus aujourd'hui, la limite haute de température acceptable pour les transistors des couches inférieures est de l'ordre de 600°C et de préférence inférieure à 500°C. Dans tous les cas, on ne peut respecter cette contrainte en utilisant seulement le mécanisme de diffusion.

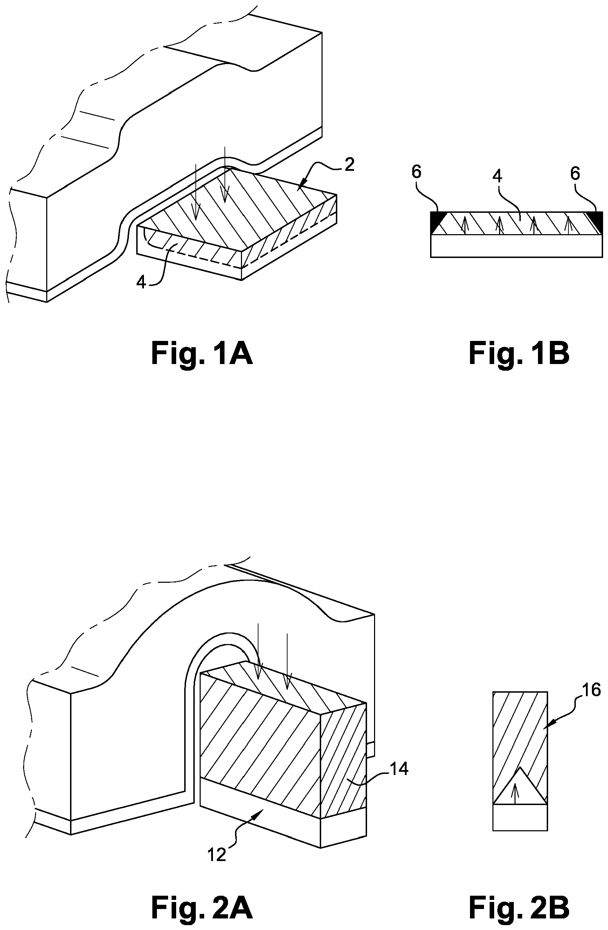

Une solution pour mettre en œuvre un dopage et une activation basse température de régions de source et de drain d'un transistor planaire (c'est-à-dire dont la structure de canal s'étend dans une couche plus large qu'épaisse) est d'utiliser un autre mécanisme comme le passage bref en phase liquide. Ainsi, un procédé basse température consiste à implanter verticalement des dopants (figure 1A) dans une couche semi-conductrice 2 en rendant des zones 4 de cette couche partiellement amorphes, puis (figure 1B) à appliquer un traitement thermique en dessous de 600°C pour recristalliser en phase solide les zones 4 rendues amorphes tout en activant les dopants.

De petites portions 6 disposées au niveau des bords latéraux supérieurs de la couche semi-conductrice 2 sont susceptibles de ne pas recristalliser correctement. Etant donnée la géométrie de la structure finale du transistor, l'impact de ces portions mal recristallisées est négligeable dans le fonctionnement du transistor.

Un tel procédé peut difficilement être appliqué tel quel à un transistor finFET comme cela est illustré sur les figures 2A-2B.

Après avoir réalisé l'implantation verticale de dopage et d'amorphisation (figure 2A) d'une zone 14 d'une structure d'ailette 12 en silicium d'un fin-FET, on effectue une recristallisation de cette zone. Le front de recristallisation s'arrête rapidement en produisant des facettes intempestives 16 d'orientation cristalline <111> (figure 2B).

Il se pose donc le problème de trouver un nouveau procédé, de préférence à basse température qui permette le dopage et l'activation de dopants d'une structure finFET tout en apportant des améliorations vis-à-vis d'inconvénients mentionnés ci-dessus.

### EXPOSÉ DE L'INVENTION

Un but de la présente invention est de proposer un nouveau procédé de dopage d'une structure semi-conductrice comportant une ou plusieurs ailettes ('fin') pour la mise en œuvre d'un ou plusieurs transistors finFET.

Un mode de réalisation de la présente invention prévoit un procédé comprenant les étapes consistant à :
a) rendre amorphe et doper une première portion d'une ailette en matériau semi-conducteur cristallin à l'aide d'au moins une première implantation inclinée au moyen d'un faisceau dirigé vers une première face latérale de l'ailette, la première portion rendue amorphe et dopée étant disposée contre la première face latérale et s'étendant jusqu'à une zone donnée de l'ailette située entre la première face latérale et une deuxième face latérale de l'ailette opposée à la première face latérale, un premier bloc semi-conducteur cristallin étant conservé contre la deuxième face latérale de l'ailette, puis
b) effectuer au moins un recuit de recristallisation de ladite première portion, puis
c) rendre amorphe et doper une deuxième portion de l'ailette au moyen d'un faisceau incliné dirigé vers la deuxième face latérale de l'ailette, la deuxième portion rendue amorphe et dopée étant disposée contre la deuxième face latérale et s'étendant jusqu'à une partie donnée de l'ailette située entre la première face latérale et la deuxième face latérale, un deuxième bloc semi-conducteur cristallin étant conservé contre ladite première face latérale de l'ailette, puis
d) effectuer au moins un recuit de recristallisation de la deuxième portion.

L'ailette s'étend sur un support dans le sens de sa longueur dans une première direction Y, et a une hauteur mesurée dans une deuxième direction Z orthogonale à la première direction, la première direction Y et la deuxième direction Z définissant un plan P1 appelé « plan longitudinal » et qui est normal au plan principal du support.

Le faisceau lors de la première implantation peut être dirigé selon une direction F1 réalisant un angle -θ1 non-nul avec la deuxième direction Z, la direction F1 du faisceau étant située dans un plan P2, normal au plan principal du support et appelé « plan transversal ». Le plan transversal P2 est séquent, ou avantageusement orthogonal, au plan longitudinal P1.

Le faisceau lors de la deuxième implantation peut être dirigé selon une direction F2 réalisant un angle +θ2 non-nul avec la deuxième direction Z.

Typiquement les directions F1, F2 sont telles que θ1= θ2.

La deuxième implantation est avantageusement symétrique de la deuxième implantation par rapport au plan longitudinal P1.

De préférence, la première et la deuxième implantation sont réalisées dans des directions situées dans le plan défini par les axes X et Z d'un repère orthogonal [O ;X ;Y ;Z].

Un tel procédé dans lequel on privilégie une implantation par les faces latérales de l'ailette peut permettre de créer un front de recristallisation dans une direction <100> ou <110>, selon l'orientation choisie des canaux des transistors par rapport au cristal de la couche de silicium. Le procédé de dopage proposé permet d'éviter ou tout au moins de limiter le phénomène de facettes bloquées lors de la recristallisation. On effectue ainsi une recristallisation plus complète de l'ailette par rapport à un procédé dans lequel on effectue une amorphisation par implantation verticale.

De préférence, on effectue le recuit de recristallisation de la première portion et/ou le recuit de recristallisation de la deuxième portion à une température inférieure à 600°C, avantageusement à une température inférieure à 500°C, le recuit de recristallisation étant généralement effectué à une température supérieure à la température minimale nécessaire au démarrage de la recristallisation qui est typiquement supérieure à 450°C.

Le procédé de dopage proposé permet de réaliser un dopage à basse température.

Lors de la première implantation et de la deuxième implantation, l'ailette peut être recouverte par un motif de grille de transistor.

Avantageusement, le procédé peut comprendre en outre, après le recuit de la deuxième portion, la formation d'espaceurs isolants de part et d'autre du motif de grille.

Ce mode de réalisation dans lequel on implante des dopants avant de déposer les espaceurs, permet d'introduire des dopants dans des portions de l'ailette situées au plus près du canal.

Un tel mode de réalisation est particulièrement adapté aux procédés dans lesquels les recuits à haute température ne sont pas autorisés, et s'intègre donc dans les procédés dits « à froid » dans lesquels les possibilités de faire diffuser des dopants sous les espaceurs sont restreintes.

Par ailleurs, même si l'on procède ensuite à un retrait de volumes de l'ailette afin de former par épitaxie des régions de source et de drain dopées et/ou exerçant une contrainte sur la structure de canal, on pourra alors conserver ces portions dopées de l'ailette.

Ainsi, selon un mode de réalisation avantageux, pour former des régions de source et de drain dopées et/ou exerçant une contrainte, on peut prévoir, après formation des espaceurs isolants des étapes de :
- gravure de premiers volumes de l'ailette de part et d'autre des espaceurs isolants, puis
- formation de régions semi-conductrices de remplacement desdites premiers volumes par croissance d'un matériau semi-conducteur dopé et/ou ayant un paramètre de maille différent du paramètre de maille dudit matériau semi-conducteur cristallin.

Le motif de grille que l'on peut prévoir sur la structure d'ailette lors des implantations est avantageusement celui d'une grille sacrificielle. Dans ce cas, le procédé comprend en outre, après formation des espaceurs isolants des étapes de :
- retrait du motif de grille sacrificielle,
- formation d'une grille de remplacement entre les espaceurs.

Un procédé suivant l'invention peut être adapté à la mise en œuvre de transistors finFET de type N et de type P sur un même support. Aussi, lorsqu'on effectue le dopage de l'ailette, on peut prévoir de protéger au moins une autre ailette de ce dopage.

Le procédé peut dans ce cas comprendre en outre préalablement à la première implantation, la formation d'un masquage à implantation sur ladite autre ailette.

Ce masquage à implantation est avantageusement en nitrure de silicium.

La réalisation du masquage à implantation peut comprendre comprend des étapes de :
- formation d'une couche de masquage recouvrant une face supérieure et des faces latérales des ailettes,
- retrait sélectif de la couche de masquage sur les faces latérales de ladite ailette tout en préservant la couche de masquage sur ladite autre ailette.

Lors de la première implantation et de la deuxième implantation, une face supérieure de ladite ailette peut être également recouverte d'un élément de masquage. On peut ainsi mettre en œuvre une première implantation et/ou une deuxième implantation dans lequel le bloc dont on conserve la structure cristalline s'étend jusqu'à la face supérieure (autrement dit jusqu'au sommet) de l'ailette.

Avantageusement, le dépôt de la couche de masquage est réalisé de sorte que la couche de masquage a une épaisseur e'1 supérieure dans une zone située sur une face supérieure des ailettes que dans une zone située contre des faces latérales des ailettes.

Un mode de réalisation particulier du masquage à implantation prévoit une couche de masquage en nitrure de silicium et des étapes :
- d'oxydation sélective d'une partie de la couche de nitrure de silicium située en regard de ladite autre ailette, tout en protégeant une autre partie de la couche de nitrure de silicium située en regard de ladite ailette,
- de gravure de cette autre partie de la couche de nitrure de silicium sélective vis-à-vis de la partie oxydée de la couche de nitrure de silicium.

Un procédé suivant l'invention s'applique à la mise en œuvre d'un dispositif à transistors finFET répartis sur un niveau de composants et permet de créer des jonctions plus abruptes que les procédés usuels utilisant un recuit de diffusion à haute température.

Un procédé suivant l'invention s'adapte tout particulièrement à la mise en œuvre d'un ou plusieurs transistors finFET d'un circuit 3D, c'est à dire comportant plusieurs niveaux superposés de transistors.

Ainsi, selon un mode de réalisation du procédé dans lequel, le dispositif est un circuit 3D doté de niveaux de transistors superposés, le ou les transistor(s) FinFET étant des transistors d'un niveau donné N₂ de transistor(s) et le support comportant au moins un niveau N₁ de transistors inférieurau niveau N2donné et ayant une région de canal agencée dans une première couche semi-conductrice, la première couche semi-conductrice étant recouverte d'au moins une couche isolante intermédiaire entre l'ailette en matériau semi-conducteur cristallin et la première couche semi-conductrice.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1B servent à illustrer un exemple de procédé de dopage et d'activation à basse température d'une structure de transistor planaire ;
- les figures 2A-2B servent à illustrer un exemple de procédé et d'activation à basse température d'une ailette de transistor finFET ;
- les figures 3A-3C illustrent un exemple de fabrication d'une structure d'ailette ;
- les figures 4A-4D servent à illustrer un exemple de procédé suivant l'invention de dopage à basse température d'une ailette de transistor finFET ;
- la figure 5 sert à illustrer un mode de réalisation particulier du procédé pour la mise en œuvre d'un transistor finFET de type N et d'un transistor finFET de type P sur un même support ;
- les figures 6A-6C servent à illustrer la formation d'un masquage à implantation apte à protéger une ou plusieurs ailettes de transistor finFET d'un type donné (N ou P) lors du dopage d'une ou plusieurs autres ailettes de transistors finFET d'un autre type (P ou N) ;
- la figure 7 sert à illustrer un exemple de réalisation particulier du masquage à implantation ;
- les figures 8A-8C servent à illustrer un exemple de réalisation particulier de blocs de source et de drain aptes à exercer une contrainte sur une structure de canal en forme d'ailette d'un transistor finFET ;
- la figure 9 sert à illustrer un exemple de réalisation d'espaceurs isolants sur une ailette après un dopage de celle-ci ;
- les figures 10A-10C servent à illustrer un mode de réalisation particulier pour la mise en œuvre d'un circuit 3D et dans lequel la couche semi-conductrice comportant les transistors finFET est rapportée sur un support déjà doté d'au moins une autre couche semi-conductrice dans laquelle des transistors ont été formés.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que «sur», « au-dessus », « verticale », « inclinée », « latérale », « supérieure », « inférieur », s'appliquent en considérant que la structure est orientée de la façon illustrée dans les figures.

### EXPOSÉ DÉTAILLÉ DE MODES DE RÉALISATION PARTICULIERS

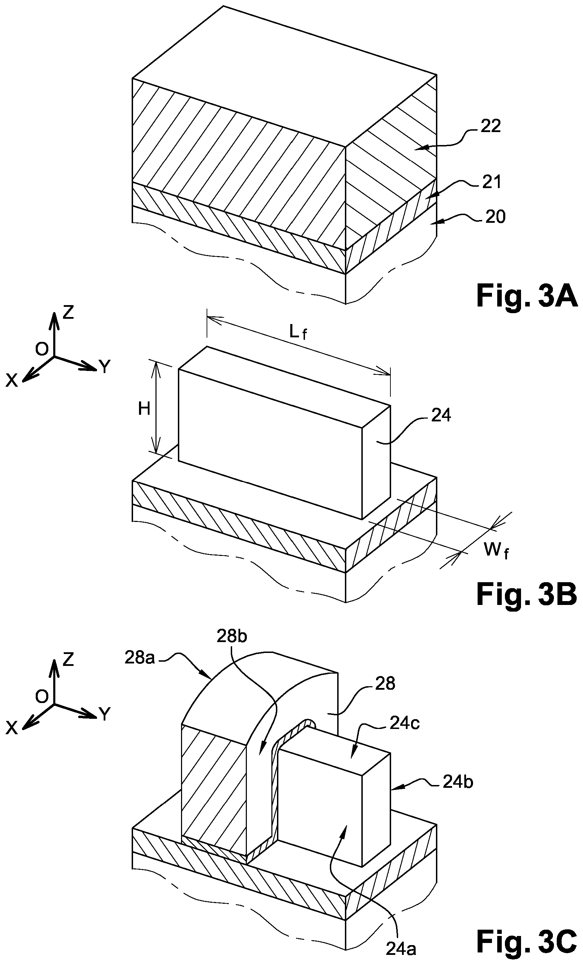

On se réfère à présent à la figure 3A qui représente une structure de départ possible d'un exemple de procédé de réalisation d'un ou plusieurs transistors finFET.

Cette structure est sous forme d'un substrat de type semi-conducteur sur isolant, en particulier de type SOI (« Silicon On Insulator »), avec une couche de support 20 semi-conductrice, une couche isolante 21 qui peut être à base d'oxyde de silicium et est disposée sur et en contact avec la couche de support 20. La couche isolante 21 du substrat est en particulier une couche de type BOX (BOX pour « Burried Oxide ») sur laquelle une couche semi conductrice superficielle 22 en matériau semi-conducteur, dans cet exemple du silicium, est agencée. La couche semi-conductrice superficielle 22 a une épaisseur typiquement comprise entre 20 et 100nm, par exemple d'au moins 35 nm.

On forme ensuite par gravure de la couche superficielle 22 au moins une ailette 24 qui peut être sous forme d'un bloc de forme parallélépipédique ou sensiblement parallélépipédique et destiné à accueillir une région de canal d'un transistor de type finFET (figure 3C). L'ailette 24 est typiquement prévue avec un rapport de forme, autrement dit un rapport de sa largeur Wf (dimension mesurée parallèlement à l'axe X d'un repère orthogonal [O ;X ;Y ;Z]) sur sa hauteur H (dimension mesurée parallèlement à l'axe Z), qui est inférieur à 1.

On forme ensuite une grille sacrificielle 28, par exemple en polysilicium, enrobant une région de l'ailette 24 dans laquelle la structure de canal du transistor finFET est prévue. La grille sacrificielle 28 est dans l'exemple illustré sur la figure 3C agencée de manière à recouvrir des zones respectivement d'une face supérieure 24c et de faces latérales 24a, 24b de l'ailette.

On cherche ensuite à doper des régions de l'ailette qui sont dévoilées et ne sont pas recouvertes par la grille sacrificielle 28. De préférence, le dopage est effectué en utilisant un faible budget thermique.

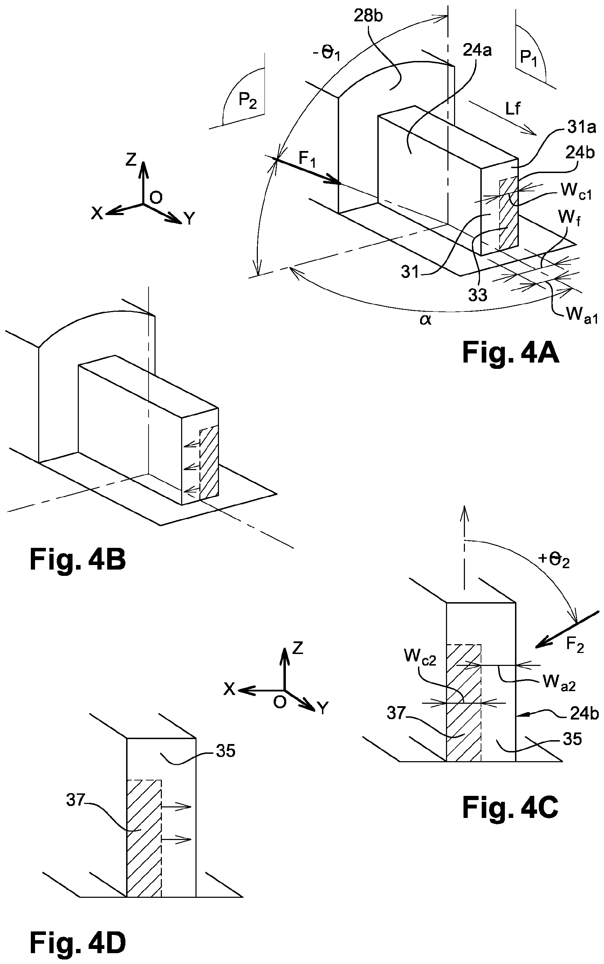

Pour cela, on prévoit un procédé suivant l'invention dont un exemple de réalisation est illustré sur les figures 4A-4D.

On effectue au moins une première implantation ionique inclinée de l'ailette 24 au moyen d'un faisceau incliné de direction F1 dirigé vers une première face latérale 24a de l'ailette 24 (figure 4A). La direction F1 du faisceau d'implantation réalise un angle -θ₁ d'inclinaison (« tilt » selon la terminologie anglo-saxonne) non-nul par rapport à un plan donné P1 que l'on appellera « plan longitudinal ».

Le plan longitudinal P1 est un plan normal au plan principal du support de l'ailette 24 et qui s'étend parallèlement à l'axe Y selon lequel la longueur L de l'ailette 24 (autrement dit la plus grande dimension de l'ailette hormis son épaisseur) est mesurée. « Par plan principal » du support, on entend un plan passant par le support et qui est parallèle au plan [O ; X ; Y] donné sur la figure 4A. Le plan longitudinal P1 est donc un plan parallèle au plan [O ; Y ; Z]. Dans l'exemple de réalisation particulier illustré sur la figure 4A, les faces latérales 24a, 24b de l'ailette 24 sont parallèles ou sensiblement parallèles au plan longitudinal P1.

La direction du faisceau d'implantation est définie dans un plan P2 appelé « plan transversal », qui est également normal au plan principal du support et coupe le plan longitudinal P1. Typiquement, le plan P2 dans lequel se trouve la direction F1 du faisceau d'implantation réalise un angle α de 90° par rapport au plan longitudinal P1.

De préférence, le plan transversal P2 dans lequel se situe le faisceau est parallèle aux faces latérales 28a, 28b de la grille sacrificielle 28. De cette manière, la grille sacrificielle 28 ne créé pas d'ombre au faisceau et l'ailette 24 peut être ainsi avantageusement dopée et rendue amorphe dans une portion s'étendant sur toute la hauteur H de l'ailette 24.

Les paramètres d'implantation, en particulier l'énergie d'implantation et la dose, sont prévus de sorte à mettre en œuvre une amorphisation partielle de l'ailette 24 dans une première portion 31 donnée située contre une première face latérale 24a de l'ailette 24 par laquelle le faisceau F1 pénètre en premier parmi les faces latérales 24a, 24b de l'ailette.

L'amorphisation partielle de l'ailette 24 est réalisée de telle sorte qu'un premier bloc 33 de matériau cristallin est conservé. Ce bloc 33 peut être délimité entre une deuxième face 24b latérale de l'ailette opposée à la première face 24a et une zone située dans le volume de l'ailette 24. De préférence, on choisit l'énergie d'implantation de sorte que la portion 31 rendue amorphe a une largeur Wa1 (dimension mesurée parallèlement à l'axe X sur la figure 4A) qui est de l'ordre de la moitié ou supérieure à la moitié de la largeur Wf totale de l'ailette 24. Le bloc 33 cristallin conservé peut avoir par exemple une largeur Wc1 de plusieurs nanomètres, par exemple de l'ordre de 3 ou 4 nm pour une ailette de largeur Wf de l'ordre de 7 nm.

La première implantation est réalisée à l'aide d'au moins une espèce dopante, par exemple du bore, ou du phosphore ou de l'arsenic, afin de réaliser un dopage de type N ou P. La concentration de dopants peut être comprise par exemple entre 1E20 et 5E20 atomes/cm³.

Avantageusement, la première implantation d'espèce dopante peut être réalisée en partie ou complétée par celle d'une espèce non-dopante, c'est-à-dire qui ne produit pas d'excès d'électrons ou de trous dans le matériau semi-conducteur de l'ailette 24. L'espèce non-dopante choisie est de préférence plus lourde que l'espèce dopante afin de favoriser l'amorphisation. On peut choisir par exemple comme espèce non-dopante des atomes de Si ou de Ge.

On réalise de préférence l'implantation de dopage et d'amorphisation à forte inclinaison, l'angle θ₁ d'inclinaison étant de préférence supérieur à 15° et typiquement compris entre 30° et 85°, avantageusement entre 30° et 45°. L'utilisation d'un angle le plus élevé possible permet de réduire la rugosité de l'interface entre la portion 31 rendue amorphe et le bloc 33 conservé cristallin et d'obtenir ainsi une interface amorphe/cristallin plus plane. Cela permet également d'obtenir une meilleure répartition des dopants et de diminuer des effets de rebond de l'espèce implantée contre la face latérale 24a par laquelle le faisceau pénètre. Cela peut également permettre de réduire l'étendue d'une partie 31a rendue amorphe et située au-dessus du bloc 33 dont on conserve la structure cristalline. L'angle maximal d'implantation utilisable peut être limité de sorte que les structures voisines ne créent pas d'ombre et permettent de doper toute la hauteur de la structure d'ailette. Cet angle maximal dépend de la hauteur de l'ailette, et de la hauteur et de la distance des structures voisines les plus proches.

Une fois la portion 31 rendue amorphe et dopée, on effectue un traitement thermique, de préférence à basse température, de sorte à réaliser une activation des dopants par recristallisation épitaxiale en phase solide (SPER pour « Solid-phase-Epitaxial Regrowth » selon la terminologie anglo-saxonne) tout en limitant le budget thermique utilisé. Un recuit est ainsi réalisé à une température typiquement comprise entre 450°C et 600°C, de préférence inférieure à Tmax, avantageusement entre 500C° et 600°C.

Le traitement thermique conduit à une recristallisation de la portion 31 rendue amorphe en se servant du bloc 33 de matériau semi-conducteur cristallin comme zone de départ d'un front de recristallisation (figure 4B). Un front de recristallisation dans une direction cristallographique <100> ou <110> est créé et ne produit avantageusement pas de facette bloquée.

Puis, après recristallisation, on effectue au moins une deuxième implantation ionique inclinée de l'ailette 24. La deuxième implantation ionique sert à doper et rendre amorphe un autre côté de la structure d'ailette 24. La deuxième implantation est donc cette fois dirigée vers une deuxième face latérale 24b de l'ailette 24 opposée à la première face latérale 24a. (figure 4C).

La deuxième implantation ionique inclinée de l'ailette 24 est ainsi réalisée au moyen d'un faisceau de direction F2 réalisant un angle +θ₂ d'inclinaison non-nul par rapport au plan longitudinal P1 et située dans le plan P2 transversal ou un plan parallèle à ce plan transversal P2.

On prévoit de préférence l'angle d'inclinaison θ₂ de la deuxième implantation tel que θ₂ = θ₁. Avantageusement, la direction F2 du faisceau lors de la deuxième implantation est symétrique de celle F1 du faisceau lors de la première implantation par rapport au plan longitudinal P1. Le faisceau lors de la deuxième implantation peut être ainsi également orienté dans une direction F2 parallèle aux flancs latéraux 28a, 28b de la grille sacrificielle 28.

La deuxième implantation est également mise en œuvre à l'aide d'une espèce dopante et effectuée de sorte à réaliser une amorphisation partielle de l'ailette 24. On utilise typiquement la ou les même(s) espèces dopantes que pour la première implantation.

L'amorphisation partielle est réalisée de telle sorte qu'une portion 35 située contre la deuxième face latérale 24b est rendue amorphe et dopée tandis qu'un bloc 37 de matériau cristallin est conservé contre la première face latérale 24a. De préférence, on choisit l'énergie d'implantation de sorte que la portion 35 rendue amorphe a une largeur Wa2 qui est de l'ordre de la moitié ou supérieure à la moitié de la largeur totale Wf de l'ailette 24. Le bloc 37 cristallin conservé peut avoir par exemple une largeur Wc2 de plusieurs nanomètres, par exemple de l'ordre de 3 ou 4 nm pour une ailette de largeur Wf de l'ordre de 7 nm. L'énergie d'implantation peut être du même ordre ou identique à celle utilisée lors de la première implantation. La portion 35 rendue amorphe s'étend de préférence sur tout la hauteur H de l'ailette 24. Comme pour la première implantation, un mode de réalisation particulier prévoit de réaliser la deuxième implantation en partie par une espèce non-dopante ou de compléter la deuxième implantation par celle d'une espèce non-dopante.

Une fois cette amorphisation et dopage effectués, on réalise au moins un deuxième traitement thermique à basse température afin d'activer les dopants. Une recristallisation épitaxiale en phase solide (SPER selon la terminologie anglo-saxonne) peut être mise en œuvre par le biais d'un recuit à une température comprise entre 450°C et 600°C. Comme cela est illustré sur la figure 4D, le bloc 37 sert de zone de départ d'un front de recristallisation.

Cette méthode de dopage, à budget thermique réduit, et lors de laquelle on implante la structure d'ailette 24 par ses faces latérales 24a et 24b plutôt que verticalement, permet d'obtenir un dopage plus complet de l'ailette 24 tout en en permettant une recristallisation complète de l'ailette et en réduisant la présence de défauts cristallins dans l'ailette 24 recristallisée.

Pour mettre en œuvre un procédé tel que décrit précédemment, une fois l'angle d'inclinaison (tilt) et la profondeur d'amorphisation définies, l'Homme du métier peut utiliser un logiciel de simulation tel que par exemple l'outil S-process™ de la société Synopsys afin de définir au mieux les paramètres d'implantation de l'ailette, notamment, d'énergie, de dose.

Différentes conditions d'implantation vont être données, à titre d'exemple, pour un transistor finFET ayant une grille de 12nm de largeur.

En utilisant un angle d'inclinaison (tilt) de 45°, l'amorphisation et le dopage de l'ailette peuvent être réalisés par implantation à l'aide de Germanium effectuée à une énergie comprise entre 2 keV et 3 keV selon une dose de 5E14 atomes/cm², suivi d'un dopage par implantation de Bore selon une dose comprise entre 3E14 et 6e14 atomes/cm² et avec une énergie de l'ordre de 2 keV.

En utilisant cette fois un angle d'inclinaison (tilt) de 30°, l'amorphisation d'une ailette peut être réalisée par implantation à l'aide de Germanium effectué à une énergie comprise entre 4 et 5 keV selon une dose de 5E14 at/cm², suivi d'une implantation de Bore selon une dose comprise entre 3E14 et 6e14 atomes/cm² et une énergie comprise entre 3 et 4 keV.

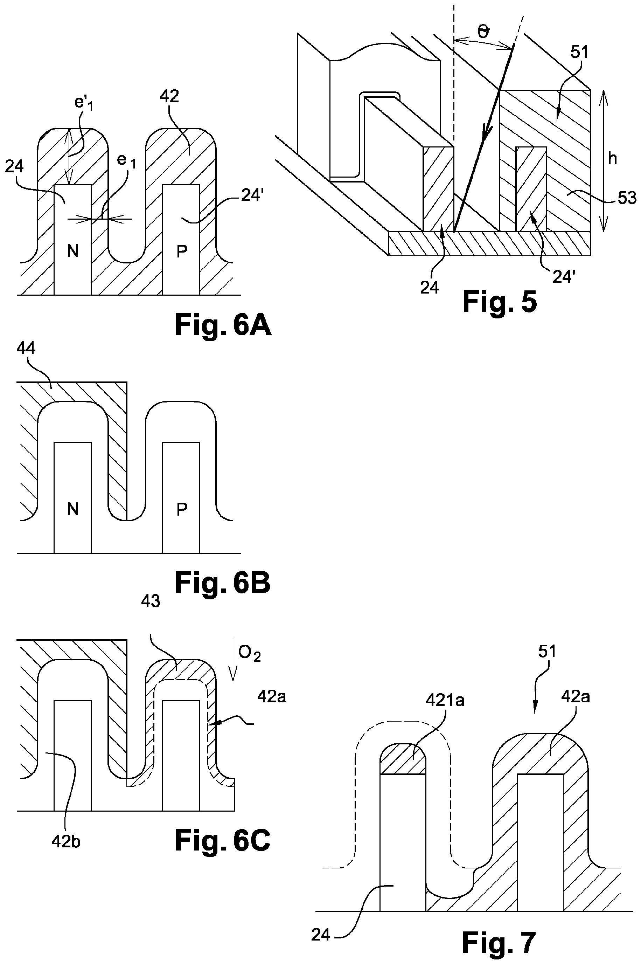

Les étapes successives de première implantation, premier recuit, deuxième implantation, deuxième recuit qui ont été décrites précédemment en lien avec les figures 4A, 4B, 4C, 4D permettent de réaliser un dopage d'un type donné, N ou P de l'ailette 24. Or, le dispositif que l'on souhaite mettre en œuvre peut comprendre des transistors finFET de type N et de type P sur un même support. Dans ce cas, pendant les étapes précitées, au moins une autre ailette 24' pour laquelle on souhaite conférer un type de conductivité, P ou N, opposé à celui de l'ailette 24 peut être protégée d'un masquage à implantation. Comme illustré sur la figure 5, de l'épaisseur d'un tel masquage à implantation 51 sur une ailette 24' peut déprendre le choix de l'angle d'inclinaison θ d'une autre ailette 24 juxtaposée.

Une fois le dopage de l'ailette 24 réalisé, pour réaliser un dopage de type opposé sur l'autre ailette 24' juxtaposée, on retire le masquage 51 et on forme un autre masquage cette fois sur l'ailette 24 précédemment dopée.

On réitère alors une séquence semblable d'étapes telles que décrites en liaison avec les figures 4A à 4D, avec cette fois au moins une autre espèce dopante adaptée à la mise en œuvre du dopage de type opposé de l'autre ailette 24'.

Afin de pouvoir réaliser un dopage par implantation tel que décrit par exemple en lien par exemple avec les figures 4A et 4C de l'ailette 24 avec un angle d'inclinaison θ suffisamment important, tout en évitant de doper l'autre ailette 24', le masquage 51 est de préférence prévu avec une hauteur h limitée. On choisit donc le matériau 53 du masquage 51 à base d'un matériau 53 capable d'avoir un fort pouvoir d'arrêt des ions tout en ayant une épaisseur faible. Le matériau 53 est de préférence également choisi de sorte à pouvoir résister aux étapes de traitement thermique décrites précédemment en lien avec les figures 4B, 4D. Dans la mesure où l'on cherche de préférence à limiter le nombre d'étapes de photolithographie, on souhaite en effet avantageusement pouvoir conserver le masquage 51 tout au long de la séquence d'étapes de première implantation, premier recuit, deuxième implantation, deuxième recuit, décrite en liaison avec les figures 4A à 4D. Ainsi, le matériau 53 choisi est de préférence différent des résines de lithographie standard utilisées habituellement comme masquage à implantation. Le pouvoir d'arrêt de telles résine est faible à épaisseur réduite ou nécessite d'utiliser une épaisseur trop importante. Par ailleurs de telles résines ne résistent généralement pas aux traitements thermiques, même à une température voisine de 500°C.

Pour répondre aux critères précités, on peut prévoir un masquage 51 par exemple en nitrure de silicium.

Un exemple de procédé de réalisation d'un masquage à implantation est illustré sur les figures 6A-6C.

On forme tout d'abord une couche 42 de masquage, par exemple en nitrure de silicium, recouvrant une face supérieure et des faces latérales des ailettes 24, 24' disposées à côté l'une de l'autre (figure 6A). Le dépôt est de préférence non-conforme, c'est-à-dire avec une épaisseur non-constante de la couche de masquage 42. Avantageusement, la couche 42 de masquage est prévue avec une épaisseur e'1 dans une région située sur la face supérieure des ailettes supérieure à celle e1 sur les faces latérales des ailettes 24, 24'.

Ensuite, on effectue un retrait sélectif d'une zone de la couche de masquage 42 située autour de l'ailette 24, de sorte à dévoiler ses faces latérales, tout en préservant la couche de masquage 42 sur l'autre ailette 24'.

Pour effectuer un tel retrait sélectif, on peut tout d'abord (figure 6B) former un masque 44, typiquement en résine photosensible, sur l'ailette 24 tandis que l'autre ailette 24' recouverte de la couche de masquage 42 n'est pas protégée par ce masque 44.

On effectue ensuite une oxydation d'une épaisseur 43 d'une partie 42a de la couche de masquage 42 située en regard de l'ailette 24' (figure 6C). Une autre partie de cette couche de masquage 42 recouverte par le masque 44 est alors protégée de l'oxydation.

On effectue ensuite un retrait du masque 44 en résine par décapage.

Puis, on grave la partie non-oxydée de la couche 42 de nitrure de silicium, typiquement à l'aide de H₃PO₄. L'épaisseur 43 oxydée de l'autre partie 42b de la couche 42 de nitrure de silicium est quant à elle résistante au procédé de gravure.

À l'issue de cette gravure, comme illustré dans l'exemple de réalisation de la figure 7, on peut préserver avantageusement un élément 421a de la couche de masquage 42 sur la face supérieure de l'ailette non-protégée par l'épaisseur oxydée. Un tel élément 421a de masquage peut être en particulier obtenu dans le cas où l'on a réalisé un dépôt non-conforme de la couche de masquage puis une gravure de préférence isotrope de cette couche de masquage 42.

En variante, pour graver la couche 42 de masquage tout en préservant un élément 421a de masquage sur le sommet de l'ailette 24, on peut effectuer une gravure sèche par plasma en utilisant un équipement permettant d'incliner le support sur lequel les ailettes 24, 24' sont disposées par rapport au plasma. La partie 42a de la couche de masquage 42 que l'on souhaite préserver peut dans ce cas être recouverte d'un masque de résine.

Le fait de préserver un élément 421a de masquage sur la face supérieure de l'ailette 24 peut permettre de réduire l'étendue de la partie 31a illustrée sur la figure 4A qui a été rendue amorphe lors de l'étape d'implantation inclinée décrite précédemment et qui se trouve au-dessus du bloc 33 dont on a conservé la structure cristalline. Ainsi, si l'on parvient à réduire cette partie et éventuellement obtenir un bloc 33 cristallin allant jusqu'à la face supérieure (autrement dit jusqu'au sommet) de l'ailette 24, on obtient ensuite une meilleure recristallisation de l'ailette 24. Cela peut permettre de réduire dans la structure finale de transistor les résistances des régions d'accès au canal.

On peut ajuster l'épaisseur de l'élément de masquage 421a préservé sur la face supérieure de l'ailette 24 en fonction des conditions d'implantation et en particulier de l'angle d'inclinaison (tilt) choisi.

On peut également adapter l'épaisseur du masquage dans la partie 42a recouvrant l'autre ailette 24' et que l'on cherche à préserver du dopage par implantation. Cette épaisseur de la partie 42a est également ajustée en fonction des conditions d'implantation et en particulier de l'angle d'inclinaison choisi. Une épaisseur trop faible permettrait à des dopants d'y entrer, tandis qu'une épaisseur trop grande limiterait l'angle d'implantation.

Pour les exemples de conditions d'implantation précédemment citées, avec un angle d'inclinaison (tilt) de 45°, un élément 421a en nitrure de silicium d'épaisseur de l'ordre de 3-4nm peut être préservé sur l'ailette 24 afin de conserver un bloc non amorphisé sur toute la hauteur de l'ailette 24. Pour un angle d'inclinaison de l'ordre de 30° on peut prévoir une épaisseur de 5 à 6nm de nitrure de silicium.

Pour empêcher une implantation de bore dans l'ailette 24' qui doit être protégée, lorsqu'une énergie d'implantation à 2 keV et un angle d'inclinaison de 45° sont utilisés, on prévoit par exemple une couche de masquage 42 de nitrure de silicium d'épaisseur d'au moins 12 nm sur l'ailette 24'.

Lorsqu'une énergie d'implantation à 4 keV et un angle d'inclinaison de 30° sont utilisés, on prévoit par exemple une couche de masquage 42 de nitrure de silicium d'épaisseur d'au moins 15 nm sur l'ailette 24'.

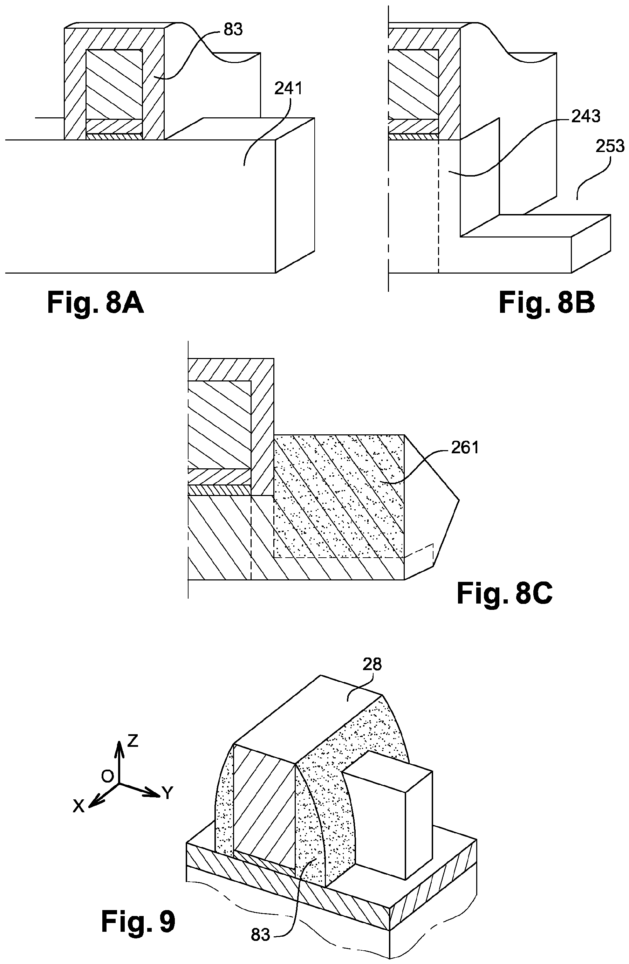

Le procédé de dopage d'ailette décrit précédemment en lien avec les figures 4A-4D s'adapte tout particulièrement au dopage de régions dites d'accès au canal d'un transistor finFET qui sont des régions située de part et d'autre de la zone de l'ailette 24 recouverte par la grille. Ces régions d'accès sont habituellement situées sous des espaceurs isolants 83 formés comme sur la figure 8 de part et d'autre de la grille. Pour permettre le dopage des régions d'accès on forme donc les espaceurs 83 de préférence après la séquence d'étapes décrites en liaison avec les figures 4A-4D.

Un exemple de procédé de réalisation des blocs de source et de drain dopés et/ou aptes à exercer une contrainte sur une structure d'ailette 24 dopée telle qu'illustrée sur la figure 8A va à présent être décrite.

On effectue tout d'abord un retrait de parties 241 de l'ailette 24 situés de part et d'autre des espaceurs 83 (figure 8B).

Ce retrait peut être réalisé à l'aide d'une gravure anisotrope, par exemple à l'aide de HCl et permet de former des cavités 253. On conserve de préférence sous les espaceurs 83 une portion 243 de l'ailette qui a été dopée à l'aide du procédé décrit précédemment en lien avec les figures 4A-4D.

On fait ensuite croitre par épitaxie un matériau semi-conducteur 261 de remplacement comblant les cavités 243 (figure 8C). Ce matériau semi-conducteur 261 peut être dopé *in-situ* c'est-à-dire durant la croissance épitaxiale.

Le matériau semi-conducteur 261 est de préférence un matériau semi-conducteur cristallin ayant un paramètre de maille différent de celui du matériau composant le reste de l'ailette 24, afin de pouvoir réaliser des régions de source et de drain exerçant une contrainte sur la région de canal. Typiquement, lorsque l'ailette 24 est initialement formée en silicium, le matériau semi-conducteur 261 que l'on fait croitre est en silicium germanium.

Dans l'exemple de réalisation illustré sur la figure 9, les espaceurs isolants 83, typiquement en nitrure de silicium, sont formés contre une grille sacrificielle 28 amenée à être remplacée ultérieurement.

La mise en œuvre des grilles de transistors finFET auxquels on applique un procédé de dopage tel que décrit précédemment peut elle-même suivre un procédé de fabrication de grille de type appelé « gate last » (grille en dernier). Dans ce cas, la grille sacrificielle 28 qui a permis notamment d'établir le dopage des régions d'accès au canal et d'introduire des dopants au plus près du canal est alors gravée entre les espaceurs 83 et remplacée par un empilement de grille final. On forme donc une grille de remplacement après le dopage et l'activation des dopants dans la ou les ailettes. Cette grille de remplacement est de préférence réalisée après la formation de régions de source et de drain.

Un procédé pour la fabrication de transistors finFET de type N et/ou P tel que décrit précédemment s'adapte tout particulièrement à une intégration dans un circuit intégré en 3 dimensions ou « 3D ».

Dans de tels circuits, des transistors sont répartis sur plusieurs niveaux de couches semi-conductrices. En utilisant un procédé de dopage à basse température tel que décrit en lien avec les figures 4A-4D, on peut intégrer un ou plusieurs transistors finFET dans un niveau supérieur d'un dispositif comportant déjà d'un ou plusieurs niveaux de transistors.

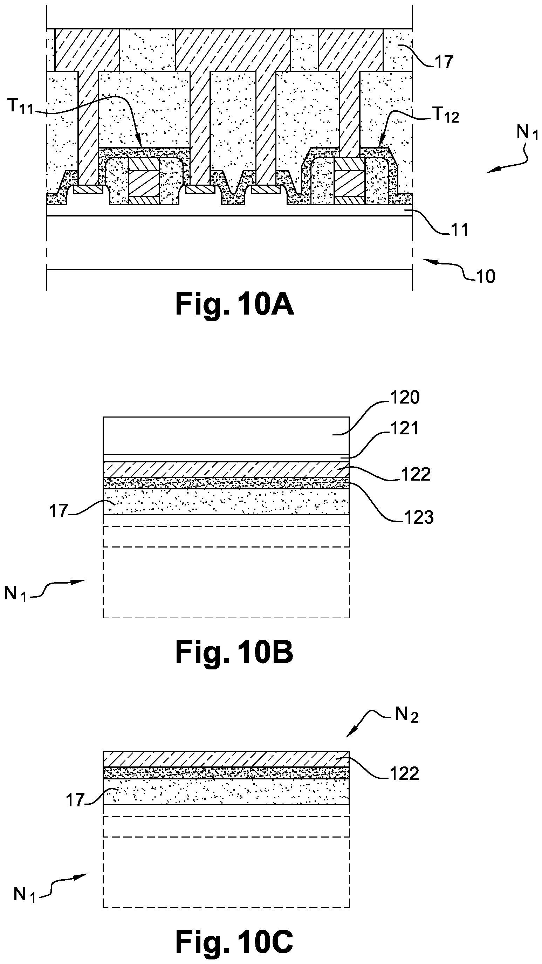

Un exemple de procédé prévoit de partir d'une structure telle qu'illustrée sur la figure 10A et déjà dotée d'au moins un niveau Ni de transistors T₁₁, T₁₂ dont la région de canal s'étend dans une couche semi-conductrice 11 reposant sur un substrat 10.

On réalise ensuite sur cette structure un report et une solidarisation, par exemple par collage moléculaire, d'un support comportant une couche semi-conductrice 122 dans laquelle un ou plusieurs transistors finFET sont aptes à être formés. Cette couche semi-conductrice 122 peut être par exemple disposée sur un substrat poignée sacrificiel formé d'une couche de support 120 semi-conductrice et d'une couche isolante 121 par exemple en oxyde de silicium.

Le transfert par collage est de préférence mis en œuvre à faible température, par exemple comprise entre 100°C et 650°C, et avantageusement inférieure à 450°C, afin de ne pas détériorer les éléments de connexion et transistors du niveau Ni inférieur.

Dans l'exemple illustré sur la figure 10B, pour faciliter l'assemblage, la couche semi-conductrice 122 est revêtue d'une couche isolante, typiquement en oxyde de silicium que l'on reporte sur une autre couche isolante 17, recouvrant le premier niveau Ni de transistors. Cette autre couche isolante 17 est typiquement en oxyde de silicium, un collage de type oxyde sur oxyde pouvant alors être mis en œuvre.

On peut ensuite retirer les couches 120, 121 du substrat poignée (figure 10C). On dispose alors d'une couche semi-conductrice 122 dans laquelle on peut former une ou plusieurs ailettes 24 et/ou 24' auxquelles on peut faire subir un procédé de dopage tel que décrit précédemment.

## Revendications

1. Procédé de réalisation d'un dispositif doté d'un ou plusieurs transistor(s) FinFET comprenant les étapes consistant à :
a) rendre amorphe et doper une première portion (31) d'au moins une structure semi-conductrice comprenant une ailette (24) en matériau semi-conducteur cristallin et s'étendant sur un support dans le sens de sa longueur dans une première direction (Y), l'ailette ayant une hauteur mesurée dans une deuxième direction (Z) orthogonale à la première direction, la première direction (Y) et la deuxième direction (Z) étant parallèles à un plan longitudinal (P1) normal au plan principal du support, la première portion (31) étant rendue amorphe et dopée à l'aide d'au moins une première implantation inclinée au moyen d'un faisceau dirigé vers une première face latérale (24a) de l'ailette et selon une direction (F1) réalisant un angle (-θ1) non-nul avec la deuxième direction (Z), la direction (F1) du faisceau étant située dans un plan transversal (P2), le plan transversal (P2) étant normal au plan principal du support et séquent, ou avantageusement orthogonal, au plan longitudinal (P1), la première portion (31) rendue amorphe et dopée étant disposée contre la première face latérale (24a) et s'étendant jusqu'à une zone donnée de l'ailette située entre la première face latérale (24a) et une deuxième face latérale (24b) opposée à la première face latérale, un premier bloc semi-conducteur cristallin (33) étant conservé contre la deuxième face latérale de l'ailette (24b), puis
b) effectuer au moins un recuit de recristallisation de ladite première portion, puis
c) rendre amorphe et doper une deuxième portion (35) de l'ailette (24) au moyen d'un faisceau dirigé vers la deuxième face latérale (24b) de l'ailette et selon une direction (F2) réalisant un angle (+θ2) non-nul avec la deuxième direction (Z), la deuxième portion (35) rendue amorphe et dopée étant disposée contre la deuxième face latérale (24b) et s'étendant jusqu'à une partie donnée de l'ailette située entre la première face latérale et la deuxième face latérale, un deuxième bloc semi-conducteur cristallin étant conservé contre ladite première face latérale (24a) de l'ailette, puis
d) effectuer au moins recuit de recristallisation de la deuxième portion (35).

2. Procédé selon la revendication 1, dans lequel lors de la première implantation et de la deuxième implantation, l'ailette (24) est recouverte par un motif de grille (28) de transistor.

3. Procédé selon la revendication 2, le procédé comprenant en outre, après le recuit de la deuxième portion, la formation d'espaceurs isolants (83) de part et d'autre du motif de grille (28).

4. Procédé selon la revendication 3, le procédé comprenant en outre, après formation des espaceurs isolants (83) des étapes de :
- gravure de premiers volumes (241) de l'ailette (24) de part et d'autre des espaceurs isolants (83), puis
- formation des régions semi-conductrices (261) de remplacement desdits premiers volumes par croissance d'un matériau semi-conducteur dopé et/ou ayant un paramètre de maille différent du paramètre de maille dudit matériau semi-conducteur cristallin.

5. Procédé selon l'une des revendications 3 ou 4, dans lequel le motif de grille (28) est celui d'une grille sacrificielle, le procédé comprenant en outre, après formation des espaceurs isolants (83) des étapes de :
- retrait du motif (28) de grille sacrificielle,
- formation d'une grille de remplacement entre les espaceurs.

6. Procédé selon l'une des revendications 1 à 5, dans lequel la structure semi-conductrice comprend une autre ailette (24'), juxtaposée à ladite ailette (24), le procédé comprenant en outre préalablement à la première implantation, la formation d'un masquage (51) à implantation sur ladite autre ailette (24').

7. Procédé selon l'une des revendications 1 à 6, dans lequel lors de la première implantation et de la deuxième implantation, une face supérieure de ladite ailette (24) est recouverte d'un élément (421a) de masquage.

8. Procédé selon la revendication 6 ou selon la revendication 7 lorsque rattachée à la revendication 6, dans lequel la réalisation du masquage (51) à implantation comprend des étapes de :
- formation d'une couche (42) de masquage recouvrant une face supérieure et des faces latérales des ailettes (24, 24'),
- retrait sélectif de la couche de masquage sur les faces latérales de ladite ailette (24) tout en préservant la couche de masquage sur ladite autre ailette (24').

9. Procédé selon la revendication 8, dans lequel le dépôt de la couche de masquage (42) est réalisé de sorte que la couche de masquage (42) a une épaisseur (e'1) supérieure dans une zone située sur une face supérieure des ailettes que dans une zone située contre des faces latérales des ailettes.

10. Procédé selon l'une des revendications 6 à 9, dans lequel le masquage (51) à implantation est en nitrure de silicium.

11. Procédé selon l'une des revendications 8 ou 9, dans lequel la couche de masquage (42) est une couche de nitrure de silicium, le procédé comprenant en outre des étapes de :
- oxydation sélective d'une partie (42a) de la couche de nitrure de silicium située en regard de ladite autre ailette (24'), tout en protégeant une autre partie (42b) de la couche de nitrure de silicium située en regard de ladite ailette (24),
- gravure de cette autre partie (42b) de la couche de nitrure de silicium sélective vis-à-vis de la partie oxydée de la couche de nitrure de silicium.

12. Procédé selon l'une des revendications précédentes, dans lequel le recuit de recristallisation de la première portion (31) et/ou le recuit de recristallisation de la deuxième portion (35) est effectué à une température inférieure à 600°C.

13. Procédé selon l'une des revendications précédentes, dans lequel, le dispositif est un circuit 3D doté de niveaux de transistors superposés, le ou les transistor(s) FinFET étant des transistors d'un niveau donné (N₂) de transistor(s) et le support comportant au moins un niveau (N₁) de transistors (T₁₁, T₁₂) inférieur au niveau donné et ayant une région de canal agencée dans une première couche semi-conductrice (11), la première couche semi-conductrice (11) étant recouverte d'au moins une couche isolante (17) intermédiaire entre l'ailette (24) en matériau semi-conducteur cristallin et la première couche semi-conductrice (11).

## Patentansprüche

1. Verfahren zur Herstellung einer Vorrichtung mit einem oder mehreren FinFET-Transistor(en), umfassend die folgenden Schritte:
a) Amorphisieren und Dotieren eines ersten Abschnitts (31) mindestens einer Halbleiterstruktur, die eine Rippe (24) aus kristallinem Halbleitermaterial enthält und sich auf einem Träger entlang ihrer Länge in einer ersten Richtung (Y) erstreckt, wobei die Rippe eine in einer zweiten Richtung (Z) orthogonal zur ersten Richtung gemessene Höhe aufweist, wobei die erste Richtung (Y) und die zweite Richtung (Z) parallel zu einer zur Hauptebene des Trägers normalen Längsebene (P1) verlaufen, wobei der erste Abschnitts (31) amorphisiert und dotiert wird mit Hilfe zumindest einer ersten schrägen Implantation mittels eines Strahls, der auf eine erste Seitenfläche (24a) der Rippe und in einer Richtung (F1) gerichtet ist, die mit der zweiten Richtung (Z) einen Winkel (-θ1) ungleich null einschließt, wobei die Richtung (F1) des Strahls in einer Querebene (P2) liegt, wobei die Querebene (P2) normal zur Hauptebene des Trägers verläuft und die Längsebene (P1) schneidet bzw. vorteilhafterweise orthogonal zu dieser verläuft, wobei der erste amorphisierte und dotierte Abschnitt (31) an der ersten Seitenfläche (24a) angeordnet ist und sich bis zu einem gegebenen Bereich der Rippe erstreckt, der zwischen der ersten Seitenfläche (24a) und einer zweiten, der ersten Seitenfläche gegenüberliegenden Seitenfläche (24b) liegt, wobei ein erster kristalliner Halbleiterblock (33) an der zweiten Seitenfläche der Rippe (24b) beibehalten wird, dann
b) Durchführen mindestens eines Rekristallisationsglühens des ersten Abschnitts, dann
c) Amorphisieren und Dotieren eines zweiten Abschnitts (35) der Rippe (24) mittels eines Strahls, der auf die zweite Seitenfläche (24b) der Rippe und in einer Richtung (F2) gerichtet ist, die mit der zweiten Richtung (Z) einen Winkel (+θ2) ungleich null einschließt, wobei der amorphisierte und dotierte zweite Abschnitt (35) an der zweiten Seitenfläche (24b) angeordnet ist und sich bis zu einem gegebenen Teil der Rippe erstreckt, der sich zwischen der ersten Seitenfläche und der zweiten Seitenfläche befindet, wobei ein zweiter kristalliner Halbleiterblock an der ersten Seitenfläche (24a) der Rippe beibehalten wird, dann
d) Durchführen mindestens eines Rekristallisationsglühens des zweiten Abschnitts (35).

2. Verfahren nach Anspruch 1,
wobei bei der ersten und zweiten Implantation die Rippe (24) mit einem Transistor-Gate-Muster (28) bedeckt wird.

3. Verfahren nach Anspruch 2,
wobei das Verfahren ferner nach dem Glühen des zweiten Abschnitts die Bildung von isolierenden Abstandshaltern (83) auf beiden Seiten des Gate-Musters (28) umfasst.

4. Verfahren nach Anspruch 3,
wobei das Verfahren ferner nach der Bildung der isolierenden Abstandhalter (83) folgende Schritte umfasst:
- Ätzen von ersten Volumina (241) der Rippe (24) auf beiden Seiten der isolierenden Abstandhalter (83), dann
- Bilden von Halbleiterbereichen (261) zum Ersetzen der ersten Volumina durch Aufwachsen eines Halbleitermaterials, das dotiert ist und/oder einen Gitterparameter hat, der sich von dem Gitterparameter des kristallinen Halbleitermaterials unterscheidet.

5. Verfahren nach einem der Ansprüche 3 oder 4,
wobei das Gate-Muster (28) das eines Opfergates ist, wobei das Verfahren nach der Bildung der isolierenden Abstandhalter (83) ferner folgende Schritte umfasst:
- Entfernen des Opfergate-Musters (28),
- Ausbilden eines Ersatzgates zwischen den Abstandshaltern.

6. Verfahren nach einem der Ansprüche 1 bis 5,
wobei die Halbleiterstruktur eine weitere Rippe (24') enthält, die neben der Rippe (24) angeordnet ist, wobei das Verfahren ferner vor der ersten Implantation die Bildung einer Implantationsmaske (51) an der weiteren Rippe (24') umfasst.

7. Verfahren nach einem der Ansprüche 1 bis 6,
wobei bei der ersten Implantation und der zweiten Implantation eine obere Fläche der Rippe (24) mit einem Maskierungselement (421a) bedeckt wird.

8. Verfahren nach Anspruch 6 oder nach Anspruch 7 in Kombination mit Anspruch 6,
wobei das Ausbilden der Implantationsmaske (51) die folgenden Schritte umfasst:
- Bildung einer Maskierungsschicht (42), die eine obere Fläche und die Seitenflächen der Rippen (24, 24') bedeckt,
- selektives Entfernen der Maskierungsschicht an den Seitenflächen der einen Rippe (24), wobei die Maskierungsschicht an der anderen Rippe (24') erhalten bleibt.

9. Verfahren nach Anspruch 8,
wobei die Abscheidung der Maskierungsschicht (42) so erfolgt, dass die Maskierungsschicht (42) in einem Bereich, der sich auf einer oberen Fläche der Rippen befindet, eine größere Dicke (e'1) aufweist als in einem Bereich, der sich an den Seitenflächen der Rippen befindet.

10. Verfahren nach einem der Ansprüche 6 bis 9,
wobei die Implantationsmaske (51) aus Siliziumnitrid besteht.

11. Verfahren nach einem der Ansprüche 8 oder 9,
wobei die Maskierungsschicht (42) eine Siliziumnitridschicht ist, wobei das Verfahren ferner folgende Schritte umfasst:
- selektive Oxidation eines Teils (42a) der Siliziumnitridschicht, welcher der weiteren Rippe (24') gegenüberliegt, während ein weiterer Teil (42b) der Siliziumnitridschicht, welcher der Rippe (24) gegenüberliegt, abgeschirmt wird,
- Ätzen dieses weiteren Teils (42b) der Siliziumnitridschicht selektiv in Bezug auf den oxidierten Teil der Siliziumnitridschicht.

12. Verfahren nach einem der vorangehenden Ansprüche,
wobei das Rekristallisationsglühen des ersten Abschnitts (31) und/oder das Rekristallisationsglühen des zweiten Abschnitts (35) bei einer Temperatur unter 600°C durchgeführt wird.

13. Verfahren nach einem der vorangehenden Ansprüche,
wobei die Vorrichtung eine 3D-Schaltung mit überlagerten Transistorebenen ist, wobei der bzw. die FinFEt-Transistor(en) Transistoren einer gegebenen Transistorebene (N₂) ist/sind und der Träger mindestens eine Ebene (N₁) von Transistoren (T₁₁, T₁₂) aufweist, die niedriger als die gegebene Ebene ist und einen Kanalbereich hat, der in einer ersten Halbleiterschicht (11) angeordnet ist, wobei die erste Halbleiterschicht (11) mit mindestens einer Isolierzwischenschicht (17) zwischen der Rippe (24) aus kristallinem Halbleitermaterial und der ersten Halbleiterschicht (11) bedeckt ist.

## Claims

1. A method for producing a device provided with one or several FinFET transistor(s) comprising the following steps:
a) making amorphous and doping a first portion (31) of at least one semiconductor structure comprising a fin (24) made from a crystalline semiconductor material and extending over a substrate in the direction of its length in a first direction (Y), the fin having a height measured in a second direction (Z) orthogonal to the first direction, the first direction (Y) and the second direction (Z) being parallel to a longitudinal plane (P1) normal to the primary plane of the substrate, the first portion (31) being made amorphous and doped using at least a first tilted implantation via a beam oriented toward a first lateral face (24a) of the fin and along a direction (F1) forming a non-nil angle (-θ1) with the second direction (Z), the direction of the beam being located in a transverse plane (P2), the transverse plane being normal to the primary plane of the support and secant, or advantageously orthogonal, to the longitudinal plane (P1), the first portion (31) made amorphous and doped being arranged against the first lateral face (24a) and extending up to a given zone of the fin located between the first lateral face (24a) and a second lateral face (24b) opposite the first lateral face, a first crystalline semiconductor block being kept against the second lateral face of the fin (24b), then
b) carrying out at least one recrystallization annealing of said first portion, then
c) making amorphous and doping a second portion (35) of the fin (24) using a beam oriented toward the second lateral face (24b) of the fin and along a direction (F2) forming a non-nil angle (+θ2) with the second direction (Z), the second portion (35) made amorphous and doped being arranged against the second lateral face (24b) and extending up to a given part of the fin located between the first lateral face and the second lateral face, a second crystalline semiconductor block being kept against the first lateral face (24a) of the fin, then
d) carrying out at least one recrystallization annealing of the second portion (35).

2. The method according to claim 1, wherein during the first implantation and the second implantation, the fin (24) may be covered by a transistor gate (28) pattern.

3. The method according to claim 2, the method further comprising, after the annealing of the second portion, the formation of insulating spacers (83) on either side of the gate pattern (28).

4. The method according to claim 3, the method further comprising, after formation of the insulating spacers (83), steps for:
- etching first volumes (241) of the fin (24) on either side of the insulating spacers (83), then
- forming semiconductor regions (261) to replace said first volumes by growth of a semiconductor material that is doped and/or that has a mesh parameter different from the mesh parameter of said crystalline semiconductor material.

5. The method according to any of claims 3 or 4, wherein the gate pattern (28) is that of a sacrificial gate, the method further comprising, after formation of the insulating spacers (83), steps for:
- removing the sacrificial gate pattern (28),
- forming a replacement gate between the spacers.

6. The method according to any of the claims 1 to 5, wherein the semiconductor structure comprises another fin (24'), adjacent to said fin (24), the method further comprising, before the first implantation, forming an implantation mask (51) on said other fin (24').

7. The method according to any of the claims 1 to 6, wherein during the first implantation and the second implantation, an upper face of said fin (24) is covered with a mask element (421a).

8. The method according to claim 6 or claim 7 when attached to claim 6, wherein the production of the implantation mask (51) comprises the following steps:
- forming a mask layer (42) covering an upper face and lateral faces of the fin (24, 24'),
- selectively removing the mask layer on the lateral faces of said fin (24) while preserving the mask layer on said other fin (24').

9. The method according to claim 8, wherein the deposition of the mask layer (42) is done such that the mask layer has a greater thickness (e'1) in a zone located on an upper face of the fins than in a zone located against the lateral faces of the fins.

10. The method according to claim 6, wherein the implantation mask (51) is made from silicon nitride.

11. The method according to any of claims 8 or 9, wherein the mask layer is a layer of silicon nitride (42), the method further comprising the following steps:
- selective oxidation of a portion (42a) of the silicon nitride layer located across from said other fin (24'), while protecting another portion (42b) of the silicon nitride layer located across from said fin (24),
- selective etching of said other portion (42b) of the nitride layer across from the oxidized portion of the silicon nitride layer.

12. The method according to any of the preceding claims, wherein the recrystallization annealing of the first portion (31) and/or the recrystallization annealing of the second portion (35) is done at a temperature below 600°C.

13. The method according to any of the preceding claims, wherein the device is a 3D circuit provided with levels of superimposed transistors, the FinFET transistor(s) being transistors of a given level (N₂) of transistor(s) and the substrate including at least one level (N₁) of transistors (T₁₁, T₁₂) below the given level and having a channel region arranged in a first semiconductor layer (11), the first semiconductor layer (11) being covered with at least one intermediate insulating layer (17) between the fin (24) made from crystalline semiconductor material and the first semiconductor layer (11).
